Europäisches Patentamt

European Patent Office

Office européen des brevets

(19)

(11) Publication number: **0 064 383**
A2

# (12) EUROPEAN PATENT APPLICATION

(21) Application number: 82302168.8

(22) Date of filing: 27.04.82

(51) Int. Cl.³: **H 01 L 23/04**
**H 01 L 25/04**

(30) Priority: 06.05.81 GB 8113760

(43) Date of publication of application:
10.11.82 Bulletin 82/45

(84) Designated Contracting States:
DE FR GB IT

(71) Applicant: LUCAS INDUSTRIES public limited company
Great King Street
Birmingham, B19 2XF(GB)

(72) Inventor: Rohsler, Ivor Carl
52 Fellows Lane
Harborne Birmingham, B17 9TP(GB)

(74) Representative: Carpenter, David et al,
MARKS & CLERK Alpha Tower ATV Centre
Birmingham B1 1TT(GB)

(54) A semi-conductor package.

(57) A semi-conductor package comprising an electrically and thermally conductive body (13, 14) defining a heat sink for the package, a thyristor (11) mounted on the body and having one of its anode and cathode terminals electrically connected thereto, a plurality of diodes (12) mounted on the body (13, 14) in angularly spaced relationship around the thyristor (11), each diode (12) having one terminal of opposite polarity to said one terminal of the thyristor (11) electrically connected to the body (13, 14) at least one electrically conductive element (19) extending between and electrically connecting the other terminal of each diode (12) and the other of said anode and cathode terminals of the thyristor (11), housing (13, 23, 25, 26) isolating the thyristor and the diodes from atmosphere, and a conductive contact member (27, 21) electrically connected to the gate of the thyristor (11) and exposed at the exterior of said housing.

FIG.1.

FIG.2.

EP 0 064 383 A2

This invention relates to a semi-conductor package of the kind including, as active components, a thyristor and a diode, the diode having its anode connected to the cathode of the thyristor and its cathode connected to the anode of the thyristor.

One practical application of a semi-conductor package of the kind specified is in a thyristor chopper circuit for controlling operation of an electric motor powering an electrically driven vehicle. In such an application, the active components of the package must be capable of dealing with very high currents, i.e. in excess of 150 amps, and a problem exists in producing a suitable package at a reasonable cost. For example, in one suitable known form of semi-conductor package of the kind specified, the thyristor and diode are integrated in a single semi-conductor chip with the diode being in annular form surrounding the thyristor. It is, however, found that the manufacture of such an integrated device results in a high percentage of faulty components so that the manufacturing costs are high. In addition, since discrete thyristor and diode packages must be relatively massive in order to provide the required high current rating, it is found that the connections between the diode and the thyristor packages have an undesirably large inductance. It is therefore an object of the present invention to overcome or alleviate the above-mentioned disadvantages experienced in the prior art.

Accordingly, the invention resides in a semi-conductor package comprising an electrically and thermally conductive body defining a heat sink for the package, a thyristor mounted on the body and having one of its anode and cathode terminals electrically connected thereto, a plurality of diodes mounted on the body in angularly spaced relationship around the thyristor, each diode having one terminal of opposite polarity to said one terminal of the thyristor electrically connected to the body, at least one electrically conductive element extending between and electrically connected to other terminal of each diode and the other of said anode and cathode terminals of the thyristor, housing means isolating the thyristor and the diodes from atmosphere, and a conductive contact member electrically connected to the gate of the thyristor and exposed at the exterior of said housing means.

In the package described in the preceding paragraph, the discrete thyristor can be manufactured with high yield and therefore low cost, even when the thyristor has a high continuous current rating. In the case of the diodes, since the total current flowing in use through the package is divided between a number of components, each diode can be a low cost component having a relatively small continuous current rating, provided the total rating of the diodes is sufficient to provide the package with the required current-carrying capacity. Moreover, since low rated diodes can be used, each diode can be physically small so that the electrical connections between the diodes and the thyristor can have a lower inductance than that of the prior art package described previously.

Preferably, the thyristor is physically separate from the body and the or each conductive element, but is urged into pressure contact therewith.

Preferably, each diode is bonded to the body and the or its associated conductive element.

Preferably, there is a single conductive element having a central portion which is connected to said other terminal of the thyristor and a plurality of radially extending fingers, each connected to a respective diode, the central portion of the conductive element being formed with an opening through which the gate terminal of the thyristor is exposed, and said contact member includes a portion extending through said opening into electrical contact with said gate terminal.

In the accompanying drawings, which illustrate one example of the invention;

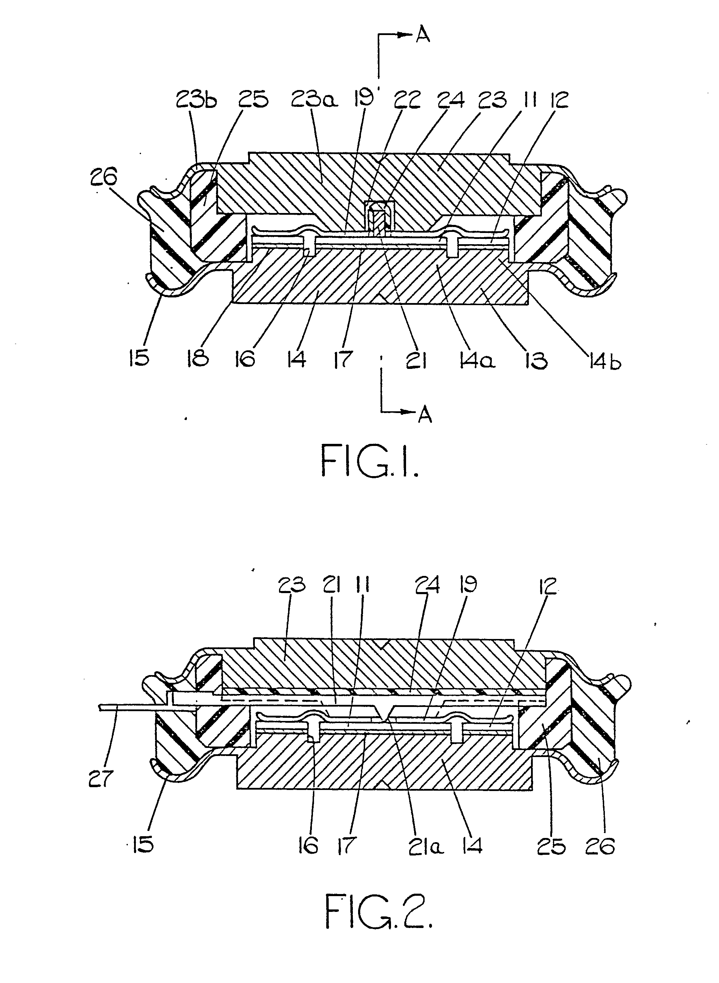

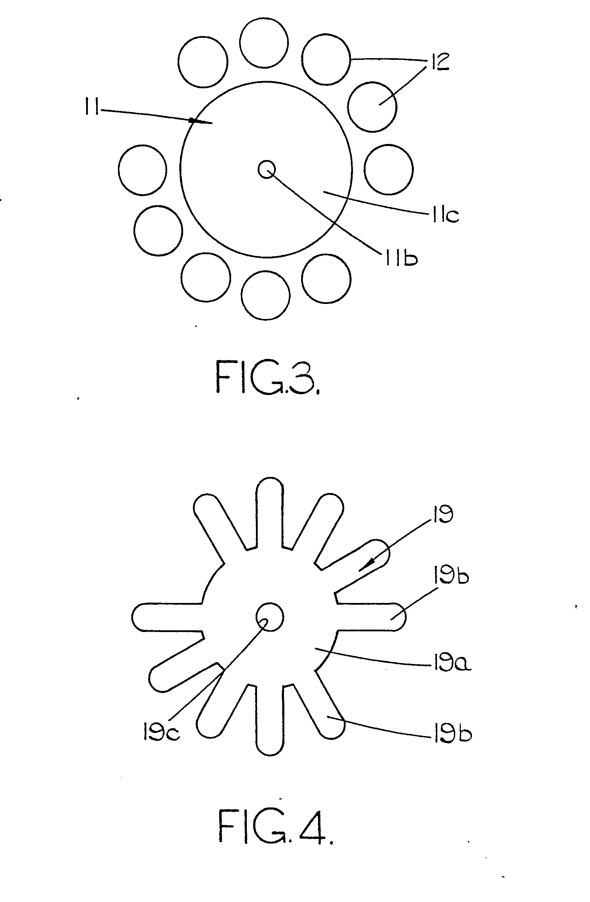

Figure 1 is a sectional view of a semi-conductor package;

Figure 2 is a sectional view along the line A-A' in Figure 1;

Figure 3 is a plan view illustrating the arrangement of the thyristor and diodes in the package; and

Figure 4 is a plan view of a lead frame providing electrical connections between the thyristor and the diodes of the package.

Referring to the drawings, the active components of the package are a thyristor 11 and a plurality of diodes 12, the cathode of the thyristor being connected to the anodes of the diodes and the cathodes of the diodes being connected to the anode of the thyristor. In one practical embodiment, in which the package is intended for use in a thyristor chopper circuit for controlling an electric motor, the thyristor 11 is a 170A R M S thyristor and is connected to ten diodes 12 each rated at 22A.

The thyristor 11 and diodes 12 are mounted as discrete devices on a header 13 formed of an electrically and thermally conductive material, conveniently copper, which defines a heat sink for the package. The header 13 is composed of a relatively massive, circular body 14 and an annular, deformable flange 15 projecting therefrom. The header 13 is of the type normally used as the heat dissipating mount of a thyristor, but is arranged to have a larger diameter body 14 than would conventionally be used with the particular thyristor 11. Thus in said one practical embodiment, although the thyristor 11 had an external diameter of only 25mm, the diameter of the body
14 was 45mm. Formed in one surface of the body 14 is an
annular groove 16 which divides the body 14 into a central
portion 14a and an annular outer portion 14b. In said one
practical embodiment, the groove 16 had a radial width of
1mm, a depth of 1mm and an internal diameter of 25mm.

The thyristor 11, which has its anode exposed at one
major surface thereof and its cathode and gate exposed at
the other major surface, is secured at said one surface to
a molybdenum pad 17, conveniently by means of a 95% lead/5%
tin solder. The pad 17, with the thyristor joined thereto,
is mounted on, but not bonded to, the central portion 14a
of the header 13 and, as described in detail below, in the
assembled package the pad 17 is urged into pressure contact
with the portion 14a so that the anode of the thyristor is
electrically and thermally connected to the header.

The diodes 12 have molybdenum pads 18 secured to their
cathode surfaces, again conveniently by way of a 95%
lead/5% tin solder and the pads 18 are secured to the outer
portion 14b of the header 13, conveniently by way of a 40%
lead/60% tin solder (i.e. having a lower melting point than
the 95% lead/5% tin solder used to bond the pads to the
diodes). The diodes 12 are arranged on the outer portion
14b in two groups of, or near to, equal numerical size.
In each group, the diodes are spaced apart equi-angularly
so that in said one practical embodiment there was a
minimum clearance of 1mm between adjacent diodes in each
group of 5 diodes. The two groups of diodes are, however,
spaced apart by a greater distance so that, as will be
described in detail below, there is sufficient access for a
gate contact of the thyristor 11.

The cathode of the thyristor 11 and the anodes of the
diode 12 are exposed at the upper surfaces of their
respective devices and are electrically connected by a lead frame 19, conveniently formed of gold-plated copper. The lead frame 19 includes an annular central portion 19a from which extend a plurality of radially extending fingers 19b equal in number to, and arranged in the same spatial relationship as, the diodes on the header portion 14b. The fingers 19b of the lead frame are secured to the diodes 12 respectively, again conveniently by way of a 95% lead/5% tin solder. There is, however, no physical bond between the central portion 19a of the lead frame and the cathode terminal of the thyristor although, in the assembled header, the central portion 19a of the lead frame is urged into pressure contact with the cathode terminal of the thyristor. The aperture 19c in the central portion 19a of the lead frame is arranged so as to be aligned with the gate terminal of the thyristor 11 and to be of increased dimensions as compared with said gate terminal so that the gate of the thyristor is electrically isolated from the lead frame. The gate and cathode terminals of the thyristor are indicated at 11b and 11c respectively in Figure 3.

Electrical connections to the gate terminal 11b are made by way of an elongated contact strip 21 which is formed with a projecting nose 21a which extends through the aperture 19c in the lead frame 19 into contact with the terminal 11b. The contact strip 21 is received in a groove 22 in a thermally and electrically conductive cover 23 and is insulated from the cover by a non-conductive spacer 24. The cover 23 is of similar shape and dimensions to the header 13 and is also conveniently formed of copper. Thus the cover 23 includes a central portion 23a and a deformable annular flange 23b, the central portion 23a urging the central portion 19a of the lead frame 19 into pressure contact with the cathode terminal 11c of the thyristor. The cover 23 thereby allows external electrical connections to be made to the cathode terminal 11c as well as providing a further heat sink for the package.

0064383

Sealing the active components of the package from atmosphere are a silicone rubber collar 25 and a synthetic resin sleeve 26 which is moulded around the collar 25 and between the flanges 15, 23b. During moulding of the sleeve 26, the header 13 and cover 23 are urged towards each other such that the flanges 15, 23b are resiliently deformed and the thyristor is sandwiched in pressure contact between the header 13 and the lead frame 19. Thereafter, in the assembled package, the sleeve 26 retains the header 13 and cover 23 in position to maintain the pressure contact on the thyristor.

The contact strip 21 is arranged to extend through the collar 25 into electrical contact with a terminal member 27 which is moulded into the sleeve 26 and which, in use, allows external electrical connections to be made to the gate of the thyristor 11. In addition, the package conveniently includes a synthetic resin spacer (not shown) which fits between the diodes 12 and the thyristor 11 to retain the thyristor in position on the header 13 during and after assembly of the package.

The package described above is conveniently manufactured as follows:

The molybdenum pads 18 are soldered to their respective diodes 12 and, after testing the resultant diode assemblies, the assemblies are soldered in the required position on the annular outer portion 14b of the header 13, conveniently with the aid of a jig to achieve accurate alignment. The thyristor 11, with the molybdenum pad 17 soldered thereto, is then assembled onto the central portion 14a of the header, whereafter the lead frame 19 is located in place with its central portion 19a engaging the cathode terminal 11b of the thyristor and its fingers 19b engaging the diodes 12 respectively. The surface of each finger 19b presented to its associated diode 12 is provided with raised solder lands, and, when the lead frame is in place, the fingers 19b are re-flow soldered to the diodes 12. The collar 25, with the contact strip 21 extending therethrough, is then engaged with the cover 23 so that the contact strip 21 is received in the groove 22 with the spacer 24 being trapped between the strip 21 and the cover 23. The cover assembly is then mounted onto the lead frame 19 so that the central portion 23a of the cover 23 engages the central portion 19a of the lead frame and nose 21a of the contact strip 21 extends through the aperture 19c into contact with the gate terminal 11b. Thereafter, with the cover 23 and header 13 clamped in a suitable jig, the sleeve 26 is moulded in place around the collar 25 and the terminal member 27.

CLAIMS:

1. A semi-conductor package including, as active
components, a thyristor and a diode, the diode having its
anode connected to the cathode of the thyristor and its
cathode connected to the anode of the thyristor,
characterized in that, the package comprises an
electrically and thermally conductive body (13, 14)
defining a heat sink for the package with the thyristor
(11) mounted on the body and having one of its anode and
cathode terminals electrically connected thereto, a
plurality of diodes (12) mounted on the body (13, 14) in
angularly spaced relationship around the thyristor (11),
each diode (12) having one terminal of opposite polarity
to said one terminal of the thyristor (11) electrically
connected to the body (13, 14) at least one electrically
conductive element (19) extending between and electrically
connecting the other terminal of each diode (12) and the
other of said anode and cathode terminals of the thyristor
(11), housing means (23, 25, 26) isolating the thyristor
and the diodes from atmosphere, and a conductive contact
member (27, 21) electrically connected to the gate of the
thyristor (11) and exposed at the exterior of said housing
means.

2. A semi-conductor package as claimed in Claim 1,
characterized in that the thyristor (11) is physically
separate from the body (13, 14) and the or each conductive
element (19) but is urged into pressure contact therewith.

3. A semi-conductor package as claimed in claim 1 or
claim 2 characterized in that each diode is bonded to the
body (13, 14) and the or its associated conductive element
(19).

0064383

4.    A semi-conductor package as claimed in any one of the preceding claims, characterized in that there is a single conductive element (19) having a central portion (19a) which is connected to said other terminal of the thyristor (11) and a plurality of radially extending fingers (19b), each connected to a respective diode (12), the central portion (19a) of the conductive element (19) being formed with an opening (19c) through which the gate terminal of the thyristor (11) is exposed, and said contact member (27, 21) includes a portion (21a) extending through said opening into electrical contact with said gate terminal.

0064383

1/2

FIG.1.

FIG.2.

FIG.3.

FIG.4.